# EUROPEAN PATENT APPLICATION

(11) **EP 3 862 161 A1**
(43) Date of publication of application: **11.08.2021**
(21) Application number: 19869354.1
(22) Date of filing: 01.10.2019
(51) Int. Cl.: B29C 33/68, C08J 5/18, H01L 21/60, H01L 21/603

(54) **HEAT-RESISTANT RELEASE SHEET AND THERMOCOMPRESSION BONDING METHOD**

(30) Priority: 04.10.2018 JP 2018189069
(71) Applicant: NITTO DENKO CORPORATION, Ibaraki-shi Osaka 567-8680 (JP)
(72) Inventor: AKIBA, Kurato, Ibaraki-shi, Osaka 567-8680 (JP); YOSHIMATSU, Kimihiko, Ibaraki-shi, Osaka 567-8680 (JP)
(74) Representative: Müller-Boré & Partner Patentanwälte PartG mbB
(86) International application number: PCT/JP2019/038803
(87) International publication number: WO 2020/071387

(57) **Abstract**

A heat-resistant release sheet of the present disclosure is a sheet formed of a single-layer heat-resistant resin film having a thickness of 35 µm or less, wherein the sheet is disposed between a compression bonding target and a thermocompression head at the time of thermocompression-bonding the compression bonding target by the thermocompression head to prevent fixation between the compression bonding target and the thermocompression head, and a heat-resistant resin forming the heat-resistant resin film has a melting point of 310°C or higher and/or a glass transition temperature of 210°C or higher. A use temperature of this heat-resistant release sheet can be, for example, 250°C or higher. The heat-resistant release sheet of the present disclosure can more reliably meet a demand for an increase in thermocompression bonding temperature.

## Description

### TECHNICAL FIELD

The present invention relates to a heat-resistant release sheet and a thermocompression bonding method using the same.

### BACKGROUND ART

Thermocompression bonding is used for manufacturing and flip chip mounting of semiconductor chips using an underfill such as a non-conductive film (NCF) and a non-conductive paste (NCP) and for manufacturing of printed circuit boards (PCBs). Thermocompression bonding is also used, for example, for bonding of an electronic part to a PCB by using an anisotropic conductive film (ACF). A thermocompression head, which is a heat source as well as a pressure source, is generally used to thermocompression-bond a compression bonding target. In order to prevent fixation between the compression bonding target and the thermocompression head at the time of thermocompression bonding, a heat-resistant release sheet is commonly disposed between the compression bonding target and the thermocompression head.

In Patent Literature 1 is disclosed, though not a heat-resistant release sheet itself, a release sheet used in a mold when a thermosetting resin is molded, the release sheet including a fluorosilicone release layer formed on at least one surface of a thermoplastic resin film.

### CITATION LIST

### Patent Literature

Patent Literature 1: JP 2011-201033 A

### SUMMARY OF INVENTION

### Technical Problem

A further increase in thermocompression bonding temperature at the time of thermocompression-bonding a compression bonding target is expected. The further increase in thermocompression bonding temperature makes it possible, for example, to thermocompression-bond a compression bonding target in which more layers than ever are laminated and to improve manufacturing efficiency and mounting efficiency of semiconductor chips. However, the release sheet of Patent Literature 1 is based on the assumption that the release sheet is used up to about 200°C, which is a common molding temperature of thermosetting resins. Patent Literature 1 gives no consideration at all to the expected further increase in thermocompression bonding temperature in thermocompression bonding by a thermocompressing head. Moreover, the release sheet of Patent Literature 1 is a release sheet to be used for molding a thermosetting resin, and is not supposed to be used for thermocompression bonding by a thermocompressing head.

The present invention is intended to provide a heat-resistant release sheet that can more reliably meet a demand for a further increase in thermocompression bonding temperature in thermocompression bonding by a thermocompressing head.

### Solution to Problem

The present invention provides a heat-resistant release sheet formed of a single-layer heat-resistant resin film having a thickness of 35 µm or less, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
a heat-resistant resin forming the heat-resistant resin film has a melting point of 310°C or higher and/or a glass transition temperature of 210°C or higher.

In another aspect, the present invention provides a method for thermocompression-bonding a compression bonding target by a thermocompression head, the method including thermocompression-bonding the compression bonding target by the thermocompression head with a heat-resistant release sheet disposed between the thermocompression head and the compression bonding target, wherein
the heat-resistant release sheet is the above heat-resistant release sheet of the present invention.

### Advantageous Effects of Invention

Firstly, the heat-resistant resin film forming the heat-resistant release sheet of the present invention has a high heat resistance. Secondly, according to a study by the present inventors, when the release sheet of Patent Literature 1 is used for thermocompression bonding by a thermocompressing head having a further increased thermocompression bonding temperature, a compression bonding target is contaminated as a result of decomposition of the release layer on a surface of the sheet. On the other hand, the heat-resistant release sheet of the present invention can prevent contamination of a compression bonding target because the sheet is formed of the single-layer heat-resistant resin film. Thirdly, when the thermocompression bonding temperature is further increased, particularly in the case of thermocompression-bonding a compression bonding target in which more layers than ever are laminated, the heat conductivity of a heat-resistant release sheet disposed between a thermocompressing head and a compression bonding target greatly affects the efficiency of the thermocompression bonding. The heat-resistant release sheet of the present invention can ensure a good heat conductivity because the sheet is single-layered and has a thickness equal to or lower than the given thickness. By virtue of these points, the heat-resistant release sheet of the present invention can more reliably meet the demand for a further increase in thermocompression bonding temperature in thermocompression bonding by a thermocompressing head.

Because of properties of heat-resistant resins forming heat-resistant resin films, the heat-resistant resin films have poor cushioning properties in the thickness direction around 200°C, which is a conventional thermocompression bonding temperature. The poor cushioning properties make it difficult to uniformly apply pressure by a thermocompressing head to a compression bonding target. Therefore, persons skilled in the art have believed for a long time that heat-resistant resin films cannot be used as heat-resistant release sheets for thermocompression bonding by a thermocompressing head. However, a study by the present inventors has revealed that, surprisingly, when the thermocompression bonding temperature is increased to, for example, about 250°C and particularly about 300°C, the cushioning properties in the thickness direction can be ensured and heat-resistant resin films can be used as heat-resistant release sheets for thermocompression bonding by a thermocompressing head. The heat-resistant release sheet of the present invention has been achieved by unprecedented findings based on the above studies by the present inventors.

### BRIEF DESCRIPTION OF DRAWINGS

FIG. 1 is a cross-sectional view schematically showing an example of the heat-resistant release sheet of the present invention.
FIG. 2 is a schematic diagram illustrating an example of a thermocompression bonding method using the heat-resistant release sheet of the present invention.
FIG. 3 shows a schematic diagram illustrating a method for evaluating heat-resistant release sheets of Examples and Comparative Examples for the ability to conduct heat to a compression bonding target at the time of thermocompression bonding using a thermocompression head.

### DESCRIPTION OF EMBODIMENTS

Hereinafter, embodiments of the present invention will be described with reference to the drawings.

### [Heat-resistant release sheet]

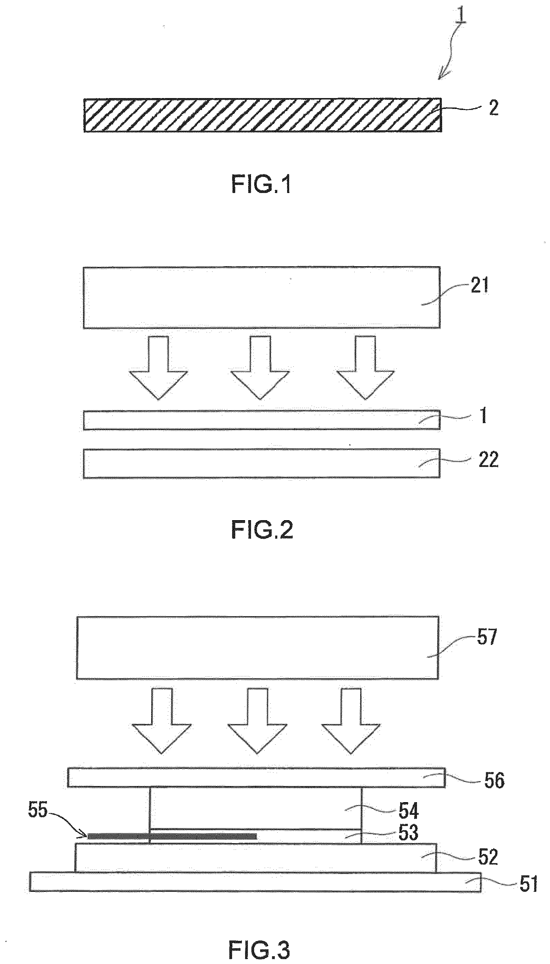

FIG. 1 shows an example of the heat-resistant release sheet of the present invention. A heat-resistant release sheet 1 shown in FIG. 1 is formed of a polyimide film 2. The heat-resistant release sheet 1 of FIG. 1 has a single-layer structure consisting of the polyimide film 2. The heat-resistant release sheet 1 has a high heat resistance derived from polyimide included in the film 2. The heat-resistant release sheet 1 has a higher heat resistance than that of a heat-resistant release sheet formed of a film formed of a fluorine resin such as polytetrafluoroethylene (PTFE) and a tetrafluoroethylene-perfluoroalkoxyethylene copolymer (PFA).

Moreover, the polyimide film 2 is less likely to deform at high temperatures, for example, than a film formed of a fluorine resin. Thus, the heat-resistant release sheet 1 formed of the polyimide film 2 is excellent in dimensional stability at high temperatures. From this view point as well, the heat-resistant release sheet 1 can more reliably meet a demand for a further increase in thermocompression bonding temperature in thermocompression bonding by a thermocompressing head.

In an industrial thermocompression bonding process, generally, a thermocompression head is positioned over a path for conveying compression bonding targets and successively thermocompression-bonds the compression bonding targets that are being conveyed one after another along the path. In this thermocompression bonding process, a strip-shaped heat-resistant release sheet is, in some cases, fed between the thermocompression head and the compression bonding target(s) by conveyance. In such cases, the heat-resistant release sheet receives a longitudinal tension caused by the conveyance as well as heat of the thermocompression head. However, a polyimide film is less elongated by a tensile force under high temperature. Therefore, the heat-resistant release sheet 1 including the polyimide film 2 can be conveyed stably to be fed as mentioned above. From this view point as well, the heat-resistant release sheet 1 can more reliably meet the demand for a further increase in thermocompression bonding temperature in thermocompression bonding by a thermocompressing head.

The polyimide film 2 and the heat-resistant release sheet 1 formed of the polyimide film 2 each have a thickness of 35 µm or less. Formed of the single-layer polyimide film 2 having a thickness of 35 µm or less, the heat-resistant release sheet 1 can ensure a good heat conductivity. The upper limit of the thickness may be 30 µm or less, 25 µm or less, or even 20 µm or less. The lower limit of the thickness is, for example, 5 µm or more, and may be more than 5 µm, 7 µm or more, or even 10 µm or more.

In an industrial thermocompression bonding process, as described above, a strip-shaped heat-resistant release sheet is, in some cases, fed between a thermocompressing head and a compression bonding target by conveyance. In such cases, it is common that a new heat-resistant release sheet is fed for each thermocompression bonding. In other words, a heat-resistant release sheet is heated from ordinary temperature to a thermocompression bonding temperature for each thermocompression bonding to conduct necessary heat to a compression bonding target. Therefore, a slight difference in heat conductivity between heat-resistant release sheets greatly affects the work time, which is the time required for thermocompression bonding. This effect becomes greater as the thermocompression bonding temperature increases, and this effect, for example, greatly change manufacturing efficiency and mounting efficiency of semiconductor chips in a thermocompression bonding process. However, the heat-resistant release sheet 1 formed of the polyimide film 2 can ensure a good heat conductivity. Therefore, the heat-resistant release sheet 1 can more reliably meet the demand for a shorter work time in addition to the demand for a further increase in thermocompression bonding temperature.

The cushioning properties of the heat-resistant release sheet 1 in the thickness direction can be evaluated in terms of indentation hardness of the sheet 1 measured in what is called "penetration mode" of thermomechanical analysis (hereinafter referred to as "TMA"). Indentation hardness, as expressed in an indentation degree A₂₅₀ given by an equation A₂₅₀ (%) = (d₂₅₀/t₀) × 100, of the heat-resistant release sheet 1 at 250°C is, for example, 3% or more, and may be 4% or more, 5% or more, 6% or more, 6.5% or more, 7% or more, or even 7.5% or more. The upper limit of the indentation degree A₂₅₀ is, for example, 15% or less. Indentation hardness, as expressed in an indentation degree A₃₀₀ given by an equation A₃₀₀ (%) = (d₃₀₀/t₀) × 100, of the heat-resistant release sheet 1 at 300°C is, for example, 3% or more, and may be 5% or more, 6% or more, 9% or more, 9.5% or more, 10% or more, 10.5% or more, or even 11% or more. The upper limit of the indentation degree A₃₀₀ is, for example, 20% or less, and may be 15% or less. t₀ is a thickness of the heat-resistant release sheet 1 at ordinary temperature (20°C). d₂₅₀ is an indentation depth evaluated for the heat-resistant release sheet 1 at 250°C using a penetration probe by TMA under the following measurement conditions. d₃₀₀ is an indentation depth evaluated for the heat-resistant release sheet 1 at 300°C using a penetration probe by TMA under the following measurement conditions.

### [Measurement conditions]

- Measurement mode: penetration mode, temperature rise measurement
- Shape and tip diameter of penetration probe: columnar shape and 1 mmϕ
- Applied pressure: 1 MPa
- Starting temperature and temperature increase rate: 20°C and 10°C/min

In the case where the heat-resistant release sheet 1 has indentation degrees A₂₅₀ and/or A₃₀₀ in the above ranges, the heat-resistant release sheet 1 can more reliably meet the demand for a further increase in thermocompression bonding temperature in thermocompression bonding by a thermocompressing head. Additionally, in that case, pressure can be more uniformly applied to a compression bonding target at the time of thermocompression bonding by a thermocompressing head, and that can increase, for example, the thermocompression bonding accuracy and thermocompression bonding efficiency of the compression bonding target.

The heat-resistant release sheet 1 has a tensile strength of, for example, 200 MPa or more, and may have a tensile strength of 220 MPa or more, 240 MPa or more, or even 260 MPa or more. The upper limit of the tensile strength is, for example, 500 MPa or less. The heat-resistant release sheet 1 having a tensile strength in these ranges can be more reliably fed between a thermocompressing head and a compression bonding target by conveyance.

The heat-resistant release sheet 1 has a maximum tensile elongation of, for example, 200% or less, and may have a maximum tensile elongation of 180% or less, 150% or less, 100% or less, 50% or less, 40% or less, or even 35% or less. The lower limit of the maximum tensile elongation is, for example, 5% or more. By virtue of the heat-resistant release sheet 1 having a maximum tensile elongation in these ranges, when the heat-resistant release sheet 1 partially adheres to a thermocompression head and/or a compression bonding target at the time of feeding the sheet 1 between the thermocompression head and the compression bonding target by conveyance, the sheet 1 can be prevented from elongating to follow these members. In other words, the releasability of the heat-resistant release sheet 1 from a thermocompression head and/or a compression bonding target can further be improved.

The polyimide film 2 and the heat-resistant release sheet 1 formed of the polyimide film 2 are commonly non-porous sheets and are impermeable sheets that allow no fluid, such as water, to permeate therethrough in the thickness direction. Including polyimide having high insulating properties, the polyimide film 2 and the heat-resistant release sheet 1 formed of the polyimide film 2 may be insulating sheets (nonconductive sheets).

The heat-resistant release sheet 1 is in the shape of, for example, a polygon such as a square or a rectangle, a circle, an oval, or a strip. The polygon may have a rounded corner. The shape of the heat-resistant release sheet 1 is, however, not limited to these examples. The polygonal-shaped, circular-shaped, or oval-shaped heat-resistant release sheet 1 can be distributed in the form of a sheet, and the strip-shaped heat-resistant release sheet 1 can be distributed in the form of a winding body (roll) formed of the sheet 1 wound around a winding core. The width of the strip-shaped heat-resistant release sheet 1 and that of the winding body formed of the strip-shaped wound heat-resistant release sheet 1 can be set to any values.

Examples of the polyimide forming the polyimide film 2 include a condensation polymer of tetracarboxylic dianhydride and diamine. However, the polyimide forming the polyimide film 2 is not limited to the above example. In the case where the polyimide is the above condensation polymer, the types of the tetracarboxylic dianhydride and the diamine are not limited. The polyimide forming the polyimide film 2 is typically an aromatic polyamide.

The heat-resistant release sheet 1 can be manufactured, for example, by a method for manufacturing common polyimide films. An example of the manufacturing method will be described hereinafter. First, a solution of polyamic acid which is a precursor of polyimide is formed from tetracarboxylic dianhydride and diamine. Next, the formed polyamic acid solution is applied to a surface of a substrate sheet. The substrate sheet is formed of, for example, a resin, a metal, paper, or a composite material thereof. The surface of the substrate sheet to which the polyamic acid solution is to be applied may have been subjected to a separation treatment for easier separation of the polyimide film from the substrate sheet. Any of known methods can be employed for the separation treatment. Any of various coaters can be used to apply the polyamic acid solution to the substrate sheet. The polyamic acid solution may be applied to the surface of the substrate sheet by immersing the substrate sheet in the polyamic acid solution. Next, imidization of the coating film of the polyamic acid solution on the surface of the substrate sheet is caused to proceed to form a polyimide film. The imidization can be caused to proceed, for example, by heating and/or addition of a catalyst. After post heating of the polyimide film is performed, as needed, for removing a solvent, etc., the formed polyimide film is separated from the substrate sheet to obtain the polyimide film 2. The obtained polyimide film 2 may be directly used as the heat-resistant release sheet 1, or may be used as the heat-resistant release sheet 1, for example, after a given treatment. The thickness of the polyimide film 2 obtained by this method can be controlled by adjusting the thickness of the polyamic acid solution applied to the substrate sheet.

The heat-resistant release sheet 1 may be formed of a heat-resistant resin other than polyimide. The heat-resistant resin has a melting point of 310°C or higher and/or a glass transition temperature of 210°C or higher. The melting point may be more than 310°C, 315°C or higher, 320°C or higher, or even 325°C or higher. The upper limit of the melting point is, for example, 400°C or less. The glass transition temperature may be 220°C or higher, 230°C or higher, 240°C or higher, or even 250°C or higher. The glass transition temperature is, for example, 300°C or less. In the present specification, the melting point of a resin refers to the peak temperature at an "endothermic peak attributed to crystal melting," the endothermic peak being measured by differential scanning calorimetry (hereinafter referred to as "DSC") in which the temperature of the resin is increased at a constant temperature rise rate, e.g., 10°C/min. In the present specification, the glass transition temperature of a resin refers to the peak temperature at an "endothermic peak attributed to a glass transition," the endothermic peak being measured by DSC in which the temperature of the resin is increased at a constant temperature rise rate, e.g.,10°C/min.

The heat-resistant resin is, for example, at least one selected from polyimide, polyetherimide, polysulfone, polyethersulfone, an aromatic polyetherketone, and polyamideimide. The heat-resistant resin may be polyimide and/or an aromatic polyetherketone. Examples of the aromatic polyetherketone include polyetheretherketone (PEEK), polyetherketone, polyetherketoneketone, and polyetheretherketoneketone. The aromatic polyetherketone may be PEEK. Fluorine resins such as polytetrafluoroethylene (PTFE), polyvinylidene fluoride, perfluoroalkoxyalkane (PFA), tetrafluoroethylene-hexafluoropropylene copolymer (FEP), and ethylene-tetrafluoroethylene (ETFE) may be excluded from examples of the heat-resistant resin.

The heat-resistant release sheet 1 formed of a heat-resistant resin film other than the polyimide film 2 can have the same configuration and/or properties as those of the above heat-resistant release sheet 1 formed of the polyimide film 2, except that the sheet 1 has a single-layer structure consisting of the heat-resistant resin film instead of a single-layer structure consisting of the polyimide film 2. Moreover, the heat-resistant resin film other than the polyimide film 2 can have the same configuration and/or properties as those of the polyimide film 2, except that the material forming the heat-resistant resin film is not polyimide but another heat-resistant resin.

The heat-resistant resin film other than the polyimide film 2 can be manufactured, for example, by any of various film formation method such as melt extrusion.

In another aspect, the present invention provides a heat-resistant release sheet formed of a single-layer heat-resistant resin film having a thickness of 35 µm or less, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
a heat-resistant resin forming the heat-resistant resin film is at least one selected from polyimide, polyetherimide, polysulfone, polyethersulfone, an aromatic polyetherketone, and polyamideimide. This heat-resistant release sheet can have the same configuration and/or properties as those of the above heat-resistant release sheet 1 formed of the polyimide film 2.

### [Use of heat-resistant release sheet]

As shown in FIG. 2, the heat-resistant release sheet 1 can be used as a heat-resistant release sheet disposed between a thermocompression head 21 and a compression bonding target 22 at the time of thermocompression-bonding the compression bonding target 22 by the thermocompression head 21 to prevent fixation between the thermocompression head 21 and the compression bonding target 22. The heat-resistant release sheet 1 has high releasability. It is possible to prevent fixation (heat fixation) of the heat-resistant release sheet 1 to the thermocompression head 21 and/or the compression bonding target 22, the fixation being caused by heat generated for thermocompression bonding.

The heat-resistant release sheet 1 may be fed and disposed between the thermocompression head 21 and the compression bonding target 22 by conveyance. The heat-resistant release sheet 1 fed and disposed by conveyance is, for example, in the shape of a strip.

Examples of the compression bonding target 22 include a semiconductor chip, a PCB, and an electronic part. The heat-resistant release sheet 1 can be used, for example, for manufacturing and flip chip mounting of semiconductor chips, manufacturing of PCBs, and bonding of electronic parts by thermocompression bonding.

The heating temperature of the thermocompressing head 21 at the time of thermocompression bonding, i.e., a use temperature of the heat-resistant release sheet 1, can be, for example, 250°C or higher. The use temperature may be 260°C or higher, 270°C or higher, 280°C or higher, 290°C or higher, or even 300°C or higher. It should be noted that the use temperature of the heat-resistant release sheet 1 is not limited to these ranges.

### [Thermocompression bonding method]

The compression bonding target 22 can be thermocompression-bonded using the heat-resistant release sheet 1 of the present invention. The thermocompression bonding method is a method for thermocompression-bonding the compression bonding target 22 by the thermocompression head 21. The thermocompression bonding method includes thermocompression-bonding the compression bonding target 22 by the thermocompression head 21 with the heat-resistant release sheet 1 disposed between the thermocompression head 21 and the compression bonding target 22. The heat-resistant release sheet 1 can be fed and disposed between the thermocompression head 21 and the compression bonding target 22, for example, by conveyance.

### [Method for manufacturing thermocompression bonded article]

A thermocompression bonded article can be manufactured using the heat-resistant release sheet 1 of the present invention. The method for manufacturing the thermocompression bonded article includes a step of thermocompression-bonding the compression bonding target 22 using the thermocompression head 21 with the heat-resistant release sheet 1 disposed between the thermocompression head 21 and the compression bonding target 22 to obtain a thermocompression bonded article which is a thermocompression bonded body of the compression bonding target 22. Examples of the thermocompression bonded article include a PCB and an electronic parts.

### EXAMPLES

Hereinafter, the present invention is described in more detail with reference to examples. The present invention is not limited to the following examples.

First, the methods for evaluating heat-resistant release sheets produced in examples will be described.

### [Releasability at the time of thermocompression bonding]

The releasability at the time of thermocompression bonding was evaluated as follows.

A semiconductor chip (size: 7.3 mm × 7.3 mm; thickness: 725 µm) serving as a simulated compression bonding target was disposed on a stage of a thermocompression bonding apparatus (a flip chip bonder FC3000W manufactured by Toray Engineering Co., Ltd.) equipped with a thermocompression head and the stage. Further, each of the heat-resistant release sheets to be evaluated was cut to a size of 75 mm × 75 mm and disposed on the semiconductor chip. The heat-resistant release sheet was disposed such that the semiconductor chip was located roughly at the center of the heat-resistant release sheet when observed in the direction perpendicular to the mounting surface of the stage. The set temperature of the stage was 120°C. Next, after the thermocompression head was lowered so as to reach a compression pressure of 20 N, the temperature of the head was increased to 300°C and a thermocompression bonding test was performed for a compression time of 10 seconds to evaluate whether heat fixation of the heat-resistant release sheet to the thermocompression head or the semiconductor chip serving as a compression bonding target occurred. The releasability was judged as good (o) when the heat-resistant release sheet was separated from the thermocompression head or the semiconductor chip by itself or by pulling the sheet by hand after the thermocompression bonding test. The releasability was judged as poor (×) when the heat-resistant release sheet was not separated by pulling the sheet by hand after the thermocompression bonding test.

### [Heat conductivity at the time of thermocompression bonding]

The heat conductivity at the time of thermocompression bonding was evaluated as follows. A specific evaluation method will be described with reference to FIG. 3.

Assuming simulated flip chip mounting, a silicon substrate 52 (thickness: 360 µm), an adhesive sheet 53 (EM-350ZT-P manufactured by NITTO DENKO CORPORATION; thickness: 60 µm) assumed to be an NCF, and a semiconductor chip 54 (size: 7.3 mm × 7.3 mm; thickness: 725 µm) were disposed in this order on a stage 51 of a thermocompression bonding apparatus (a flip chip bonder FC3000W manufactured by Toray Engineering Co., Ltd.) equipped with a thermocompression head 57 and the stage 51. A thermocouple 55 for measurement of the highest achieved temperature the adhesive sheet 53 reached in a thermocompression bonding test was inserted in the adhesive sheet 53. The thermocouple 55 was disposed such that a measuring part at its tip was located roughly at the center of the adhesive sheet 53 when observed in the direction perpendicular to the mounting surface of the stage 51. Next, a heat-resistant release sheet 56 to be evaluated was cut to a size of 150 mm × 150 mm and disposed on the semiconductor chip 54. The heat-resistant release sheet 56 was disposed such that the semiconductor chip 54 was located roughly at the center of the heat-resistant release sheet 56 when observed in the direction perpendicular to the mounting surface of the stage 51. The set temperature of the stage 51 was 120°C. Next, after the thermocompression head 57 was lowered so as to reach a compression pressure of 20 N, the temperature of the head was increased to 300°C and a thermocompression bonding test was performed for a compression time of 10 seconds to measure the highest achieved temperature the adhesive sheet 53 reached in the test using the thermocouple 55. The heat conductivity of the heat-resistant release sheet at the time of thermocompression bonding using the thermocompression head was evaluated from the measured highest achieved temperature.

### [Heat resistance]

The heat resistance was evaluated by pressing the tip of a soldering iron set to 280°C, 290°C, or 300°C. Specifically, the tip of a soldering iron set to each of the above temperatures was pressed for 10 seconds against a surface of each heat-resistant release sheet to be evaluated. The heat resistance was judged as good (o) when the surface of the heat-resistant release sheet was not molten by the heat of the soldering iron. The heat resistance was judged as poor (×) when the surface was molten.

### [Cushioning properties (indentation hardness) in thickness direction]

The indentation degrees A₂₅₀ and A₃₀₀ were evaluated by the above-described method as the cushioning properties in the thickness direction at temperatures of 250°C and 300°C, respectively. The details will be described hereinafter. First, each heat-resistant release sheet to be evaluated was cut into a 7mm × 7mm square to obtain a specimen. Next, the thickness of the specimen was measured as the thickness t₀ using a micrometer (manufactured by Mitutoyo Corporation). Subsequently, the specimen was placed on an evaluation stage of a TMA apparatus (TMA4000S manufactured by Bruker Corporation). Using a columnar penetration probe having a diameter of 1 mm, the indentation depths d₂₅₀ and d₃₀₀ by the penetration probe were measured for the specimen at 250°C and 300°C in the measurement mode of penetration mode and temperature rise measurement. The pressure applied to the specimen was a constant pressure of 1 MPa, the starting temperature was 20°C, and the temperature rise rate was 10°C/min. Then, from the measured thickness to and the measured indentation depths d₂₅₀ and d₃₀₀, the indentation degree A₂₅₀ was determined by the equation A₂₅₀ (%) = (d₂₅₀/t₀) × 100 and the indentation degree A₃₀₀ was determined by the equation A₃₀₀ (%) = (d₃₀₀/t₀) × 100.

### [Tensile strength and maximum tensile elongation]

The tensile strength (tensile strength at break) and the maximum tensile elongation were determined by a tensile test using a tensile testing machine (AG-I manufactured by Shimadzu Corporation). The tensile direction was the longitudinal direction (MD direction) of the heat-resistant release sheets. Specimens had the shape of a No. 1 dumbbell defined in JIS K 6251: 1993. The measurement conditions were such that the measurement temperature was 25°C, the test length of the dumbbell of the specimen was 40 mm, the chuck-to-chuck distance was 70 mm, and the tensile rate was 200 mm/min. The maximum tensile elongation was calculated from the above pre-test (original) test length of the dumbbell and the test length of the dumbbell at break.

### (Example 1)

A 25-µm-thick polyimide film (Kapton 100H manufactured by DU PONT-TORAY CO., LTD.) was prepared as a heat-resistant release sheet of Example 1.

### (Example 2)

A 17.5-µm-thick polyimide film (Kapton 70H manufactured by DU PONT-TORAY CO., LTD.) was prepared as a heat-resistant release sheet of Example 2.

### (Comparative Example 1)

A 25-µm-thick PFA film (NEOFLON PFAAF-0025 manufactured by DAIKIN INDUSTRIES, LTD.) was prepared as a heat-resistant release sheet of Comparative Example 1.

### (Example 3)

A 12.5-µm-thick polyimide film (Kapton 50H manufactured by DU PONT-TORAY CO., LTD.) was prepared as a heat-resistant release sheet of Example 3.

### (Example 4)

A 25 -µm-thick PEEK film (Shin-Etsu Sepla Film manufactured by Shin-Etsu Polymer Co., Ltd.) was prepared as a heat-resistant release sheet of Example 4.

Table 1 below shows the results of evaluating the properties of the heat-resistant release sheets of Examples and Comparative Example. The heat conductivity (highest achieved temperature) was unable to be measured for Comparative Example 1 because the heat-resistant release sheet was molten.

**[Table 1]**

| | | Example | | | | Comparative Example |
|---|---|---|---|---|---|---|
| | | 1 | 2 | 3 | 4 | 1 |
| Releasability (from thermocompressing head) | | ○ | ○ | ○ | ○ | × |
| Releasability (from compression bonding target) | | ○ | ○ | ○ | ○ | × |
| Heat conductivity/highest achieved temperature (°C) | | 247 | 252 | 258 | 256 | Molten |
| Heat resistance | 280°C | ○ | ○ | ○ | ○ | ○ |
| | 290°C | ○ | ○ | ○ | ○ | × |
| | 300°C | ○ | ○ | ○ | ○ | × |
| Cushioning properties in thickness direction | Indentation degree A₂₅₀ (%) | 7.2 | 7.2 | 7.2 | 4.7 | -3.8 |
| | Indentation degree A₃₀₀ (%) | 11.9 | 11.9 | 11.9 | 6.1 | 4.6 |
| Tensile strength (MPa) | | 268 | 247 | 246 | 275 | 66 |
| Maximum tensile elongation (%) | | 35 | 31 | 30 | 175 | 120 |

As shown in Table 1, the heat-resistant release sheets of Examples are excellent in heat resistance and releasability, and also exhibit excellent heat conductivities in the heat conductivity test performed assuming thermocompression bonding by a thermocompressing head. The heat-resistant release sheet of Comparative Example 1 formed of the PFA film has a negative indentation degree A₂₅₀ and a positive indentation degree A₃₀₀. These are a reflection of a large thermal expansion of the PFA film in the temperature range of 200 to 280°C and a subsequent rapid thermal softening thereof at a temperature of 280°C or higher.

### INDUSTRIAL APPLICABILITY

The heat-resistant release sheet of the present invention can be used to prevent fixation between a thermocompression head and a compression bonding target by disposing the sheet between the thermocompression head and the compression bonding target at the time of thermocompression-bonding the compression bonding target by the thermocompression head. Thermocompression bonding using the heat-resistant release sheet of the present invention is applicable, for example, to manufacturing and flip chip mounting of semiconductor chips, manufacturing of PCBs, and bonding of electronic parts.

## Claims

1. A heat-resistant release sheet formed of a single-layer heat-resistant resin film having a thickness of 35 µm or less, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
a heat-resistant resin forming the heat-resistant resin film has a melting point of 310°C or higher and/or a glass transition temperature of 210°C or higher.

2. The heat-resistant release sheet according to claim 1, wherein the heat-resistant resin film has a thickness of 25 µm or less.

3. The heat-resistant release sheet according to claim 1 or 2, wherein the heat-resistant resin is at least one selected from polyimide, polyetherimide, polysulfone, polyethersulfone, an aromatic polyetherketone, and polyamideimide.

4. The heat-resistant release sheet according to any one of claims 1 to 3, wherein a use temperature of the heat-resistant release sheet is 250°C or higher.

5. The heat-resistant release sheet according to any one of claims 1 to 4, wherein indentation hardness, as expressed in an indentation degree A₃₀₀ given by an equation A₃₀₀ (%) = (d₃₀₀/t₀) × 100, of the heat-resistant release sheet at 300°C is 3 to 15%, where t₀ is a thickness of the heat-resistant release sheet at ordinary temperature (20°C) and d₃₀₀ is an indentation depth evaluated for the heat-resistant release sheet at 300°C using a penetration probe by thermomechanical analysis (TMA) under the following measurement conditions:
[Measurement conditions]
• Measurement mode: penetration mode, temperature rise measurement
• Shape and tip diameter of penetration probe: columnar shape and 1 mmϕ
• Applied pressure: 1 MPa
• Starting temperature and temperature increase rate: 20°C and 10°C/min

6. A heat-resistant release sheet formed of a single-layer heat-resistant resin film having a thickness of 35 µm or less, wherein
the heat-resistant release sheet is disposed between a compression bonding target and a thermocompression head at the time of thermocompression-bonding the compression bonding target by the thermocompression head to prevent fixation between the compression bonding target and the thermocompression head, and
a heat-resistant resin forming the heat-resistant resin film is at least one selected from polyimide, polyetherimide, polysulfone, polyethersulfone, an aromatic polyetherketone, and polyamideimide.

7. A method for thermocompression-bonding a compression bonding target by a thermocompression head, the method comprising thermocompression-bonding the compression bonding target by the thermocompression head with a heat-resistant release sheet disposed between the thermocompression head and the compression bonding target, wherein
the heat-resistant release sheet is the heat-resistant release sheet according to any one of claims 1 to 6.
